Europäisches Patentamt

(19) European Patent Office

Office européen des brevets

(11) Publication number: **0 029 322**
**B1**

## (12) EUROPEAN PATENT SPECIFICATION

(45) Date of publication of patent specification: **25.07.84**

(51) Int. Cl.³: **G 06 F 11/20, G 11 C 8/00**

(21) Application number: **80303939.5**

(22) Date of filing: **05.11.80**

(54) Semiconductor memory device with redundancy.

(30) Priority: **13.11.79 JP 157393/79 U**

(43) Date of publication of application:
**27.05.81 Bulletin 81/21**

(45) Publication of the grant of the patent:
**25.07.84 Bulletin 84/30**

(84) Designated Contracting States:
**DE FR GB NL**

(56) References cited:
**US - A - 3 753 244**
**US - A - 3 860 831**
**US - A - 4 051 354**

(73) Proprietor: **FUJITSU LIMITED**
**1015, Kamikodanaka Nakahara-ku**
**Kawasaki-shi Kanagawa 211 (JP)**

(72) Inventor: **Takemae, Yoshihiro**
**20-5-9-301, Utsukushigaoka 1-chome Midori-ku**
**Yokohama-shi Kanagawa 227 (JP)**

(74) Representative: **Massey, Alexander et al,**
**MARKS & CLERK Scottish Life House Bridge Street**
**Manchester, M3 3DP (GB)**

## Description

The present invention relates to a semiconductor memory device including a redundancy memory cell array therein.

A semiconductor memory device comprises a large number of memory cells arranged along rows and columns which are orthogonal to each other. The density of deffects generated in such a semiconductor memory device during manufacturing is relatively independent of the integration density of the device, but is dependent on semiconductor manufacturing technology. Therefore, the higher the integration density of the device, the greater the ratio of the number of normal memory cells to the number of defective memory cells. This is one of the advantages obtained by increasing the integration density of a semiconductor memory device. However, even if the device includes only one defective memory cell therein, the device cannot operate normally, and therefore the device is abandoned.

In order to be able to operate a semiconductor memory device despite such a defective memory cell, a semiconductor memory device has been known in which a redundancy memory cell array is incorporated with a main memory cell matrix along rows or columns thereof. In this device, when a defective memory cell is detected, the redundancy memory cell array is used instead of a row memory cell array or a column memory cell array including said defective memory cell. In a semiconductor memory device including such a redundancy memory cell array, the manufacturing yield thereof can be improved.

A first previously proposed semiconductor memory device including a redundancy memory cell array therein comprises a row address decoder means for selecting one row memory cell array within a main memory cell matrix, an additional decoder means for selecting the redundancy memory cell array and a switching means for stopping the transmission of a clock signal for driving the first decoder means. The additional decoder includes a programmable read-only memory (PROM) into which a row address corresponding to a defective row to which a defective memory cell belongs is written in advance. Therefore, when said defective row address is supplied to the additional decoder, the decoder selects the redundancy memory cell array and simultaneously, activates the switching means so that the row decoder means is disabled and the defective row memory cell array is not selected. That is, the redundancy memory cell array is selected instead of the defective row memory cell array. However, in this device, since the current flowing through the switching means is relatively large, the area of switching transistors used for the switching means is large which enlarges the entire device.

A second previously proposed semiconductor device including a redundancy memory cell array therein comprises a disabling means in the row address means instead of the above-mentioned switching means. In this device, when said defective row address is supplied to the additional decoder, the decoder selects the redundancy memory array, and, simultaneously, disables all the row decoders by using the disabling means so that the defective row memory cell array is not selected. That is, the redundancy memory cell array is selected instead of the defective row memory cell array. In this device, each area of transistors used for the disabling means is relatively small, since currents flowing therethrough are small. However, a large number of such transistors, the number of which is the same as the rows of the main memory cell matrix, are necessary. As a result, the entire device is also large.

A semiconductor memory device has been suggested in which a main memory cell matrix is divided into a plurality of sub memory cell matrixes. The selection of one row memory cell array can be effected by selecting one of the sub memory cell matrixes and selecting one memory cell array among each sub memory cell matrixes. In this device, the row decoders (and the column decoders) are simple and small in electrical structure.

US—A—3860831 describes a proposed semiconductor device in which the main memory cell matrix is divided into a plurality of sub memory cell matrixes and which also includes a redundancy memory cell array in respect of each sub memory cell matrix. Essentially the described device comprises four parallel connected devices of the type referred to above as the second previously proposed device each one of which devices receives the last three inputs of a five input address. The first two inputs of the address are supplied to a main decoder which selects one of the four parallel connected devices. Thus the device of US—A—3860831 seeks to obtain the advantages of dividing the memory into submemory cell matrixes but does not avoid the problem of having to provide a large number of small transistors to disable all the decoders of the four devices. Furthermore although four redundancy memory cell arrays are provided each is specific to only one of the four devices and accordingly if two memory cell arrays fail which are both connected to the same one of the four devices they cannot both be effectively replaced by the one redundancy memory array available in the said one device.

It is an object of the present invention to provide a semiconductor memory device including a single redundancy memory cell array which device allows the disabling of the main decoder in the case of defective sub memory cell matrices with less disabling transistors and has therefore a small area.

According to the present invention, there is provided a semiconductor memory device comprising a main memory cell matrix which is divided into a plurality of sub memory cell matrixes, at least one redundancy memory cell array associated with the main memory cell matrix, a first decoder means having a first decoder section and a second decoder section, the first decoder section selecting one memory cell array from each sub memory cell matrix and the second decoder section selecting one sub memory cell matrix in accordance with a first part of received address information; a second decoder means for generating a signal to select the redundancy memory cell array and to disable the selection of a memory cell array in the main memory cell matrix by the first decoder means in accordance with the first part of the received address information, the third decoder means for selecting one memory cell from each memory cell array and from the redundancy memory cell array in accordance with a second part of received address information, and a clock for supplying a clock signal to the redundancy memory cell array and to the first decoder means, characterised in that the first decoder section receives a first portion of the first part of the address information, the signal from the second decoder means, and the clock signal to generate word driving signals so as to select the said one memory cell array from each sub memory cell matrix, and the second decoder section receives the word driving signals and a second portion of the first part of the address information to select the said one sub memory cell matrix, the first decoder section being disabled by the signal from the second decoder means to thereby disable the first decoder means.

The means necessary for disabling the first section of the first decoder means are very simple as compared with the conventional devices. Therefore, the number of transistors used for the disabling means, each area of which is small, is reduced so that the area of the entire device is reduced.

The present invention will be more clearly understood from the description as set forth below contrasting an embodiment of the present invention with the conventional devices and with reference to the accompanying drawings wherein:

Figure 1 is a block diagram illustrating one proposed semiconductor memory device including a redundancy memory cell array therein;

Figure 2 is a block diagram illustrating another proposed semiconductor memory device including a redundancy memory cell array therein;

Figures 3 and 4 are a logic circuit diagram and a circuit diagram, respectively, of the row address decoders and drivers 4' of Figure 2;

Figure 5 is a block diagram illustrating an embodiment of the semiconductor memory device including a redundancy memory cell array according to the present invention;

Figures 6 and 7 are a logic circuit diagram and a circuit diagram, respectively, of the row address decoders and drivers 9 of Figure 5;

Figures 8 and 9 are a logic circuit diagram and a circuit diagram, respectively, of the row address decoders and drivers 10 of Figure 5; and

Figure 10 is a circuit diagram of the decoder (PROM) 5 of Figure 5.

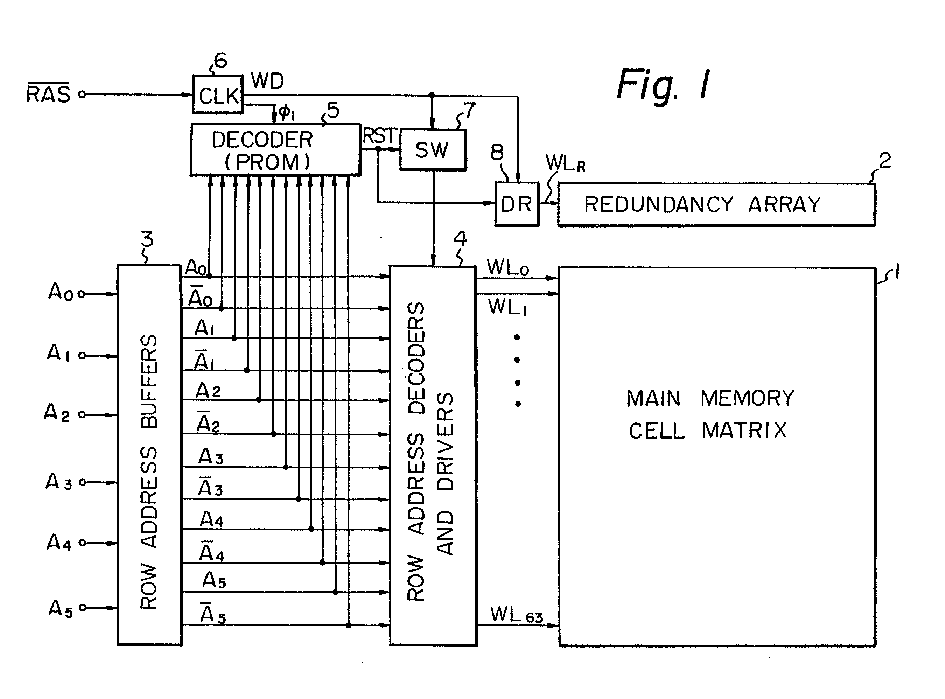

In Figure 1, which illustrates one proposed semiconductor device including a redundancy memory cell array therein, the device comprises a main memory cell matrix 1 which is, for example, 4096 ($=2^{12}$) dynamic or static MOS memory cells and a redundancy memory cell array 2 which is incorporated with the main memory cell matrix 1 along rows thereof. In addition, the device comprises row address buffers 3 for converting TTL address signals $A_0(=2^0)$, $A_1(=2^1)$, ..., $A_5(=2^5)$ into MOS level address signals $A_0, A_1, \ldots A_5$ and their inverted signals $\overline{A_0}, \overline{A_1}, \ldots \overline{A_5}$ which are supplied to row address decoders and drivers 4 for selecting one row memory cell array within the main memory cell matrix 1 and to a decoder 5, which is comprised of a PROM (programmable read-only memory), for selecting the redundancy memory cell array 2 via a driver 8.

It should be noted that, the decoders and drivers 4, the decoder 5 and the driver 8 are activated by a clock signal WD generated from a clock 6 which, in turn, receives a row address strobe signal $\overline{RAS}$. In this case, the decoders and drivers 4 receive the signal WD through a switching circuit 7.

If a defective memory cell is detected in the main memory cell matrix 1, a row address to which said defective memory cell belongs is written in the decoder (PROM) 5. Of course, when the main memory cell matrix 1 includes no defective memory cell, the decoder 5 does not perform the selection operation for the redundancy memory cell array 2.

It should be noted that the device also comprises column address buffers, column address decoders and drivers, sense amplifiers, a data input buffer, a data output buffer or the like which are, however, omitted in Figure 1.

The operation of the device of Figure 1 will be now explained.

Usually, all memory cells of the main memory cell matrix 1 of a completed semiconductor memory device are tested. After testing, if all of the memory cells of the main memory matrix 1 are determined to be normal, the operation of the device is the same as that of a memory device without the redundancy memory cell array 2, the decoder 5 and the switching circuit 7. In this case, one row array is selected from the main memory cell matrix 1 by the row address decoders and drivers 4 and, after that, one column array is selected from the main memory cell matrix 1 by the column address decoders and drivers (not shown), so that one desired memory cell at an intersecting portion of said one row array and one column is selected. Next, data stored in the desired memory cell is read out to the data output buffer (not shown), or new data of the data input buffer (not shown) is written into the desired memory cell.

Contrary to the above, if one or more defective memory cells is detected in one row memory array of the main memory cell matrix 1, a row address (hereinafter referred to as a defective row address $ADD_x$) to which said row memory cell array is written into the decoder 5 by using output signals $A_0$, $\overline{A}_0$, $A_1$, $\overline{A}_1$, . . ., $A_5$, $\overline{A}_5$ of the row address buffers 3. As a result, the decoding operation for the signals $A_0$, $\overline{A}_0$, $A_1$, $\overline{A}_1$, . . ., $A_5$, $\overline{A}_5$ of the row address buffers 3 is effected by either the row address decoders and drivers 4 or the decoder 5. For example, when the signals $A_0$, $\overline{A}_0$, $A_1$, $\overline{A}_1$, . . ., $A_5$, $\overline{A}_5$ do not correspond to the defective row address $ADD_x$, the decoder 5 does not operate, while the row address decoders and drivers 4 operate so as to select one row array among the main memory cell matrix 1. After that, the column address decoders and drivers (not shown) operate so as to select one column array of the main memory cell matrix 1. As a result, one normal memory cell of the main memory cell matrix 1 is selected. When the signals $A_0$, $\overline{A}_0$, $A_1$, $\overline{A}_1$, . . ., $A_5$, $\overline{A}_5$ correspond to the defective row address $ADD_x$, the decoder 5 generates a signal RST and activates the driver 8 so as to select the redundancy memory cell array 2 and, accordingly, any of the memory cells of the array 2 can be selected. Simultaneously, the decoder 5 disables the switching circuit 7 by the signal RST so as to stop the transmission of the clock signal WD of the clock 6 to the row address decoders and drivers 4. As a result, the decoders and drivers 4 cannot execute a selection operation even when the decoders and drivers 4 receive the signals $A_0$, $\overline{A}_0$, $A_1$, $\overline{A}_1$, . . ., $A_5$, $\overline{A}_5$ from the row address buffers 3. After that, the column address decoders and drivers (not shown) operate so as to select one memory cell of the redundancy memory cell array 2.

However, in the device of Figure 1, since the current of the clock signal WD flowing through the switching circuit 7 is relatively large, the area occupied by transistors forming the circuit 7 is relatively large so that the entire device is large.

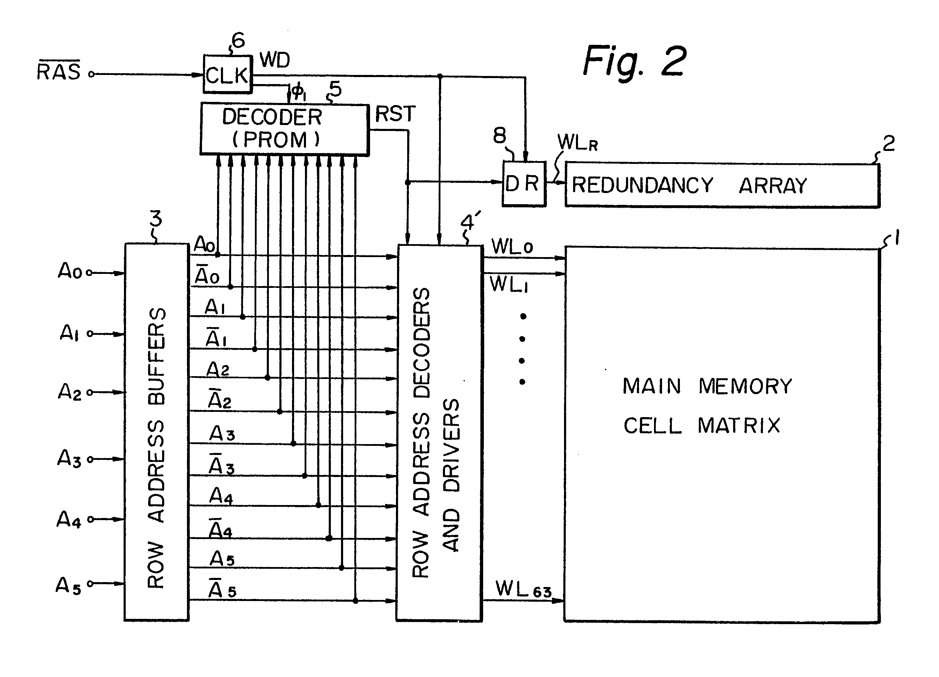

Figure 2 is a block diagram illustrating another proposed semiconductor memory device including a redundancy memory cell array therein. In Figure 2, the elements which are the same as those of Figure 1 are denoted by the same reference numerals. However, in Figure 2, the switching circuit 7 in Figure 1 is not illustrated and the signal RST of the decoder 5 is supplied directly to the row address decoders and drivers 4'.

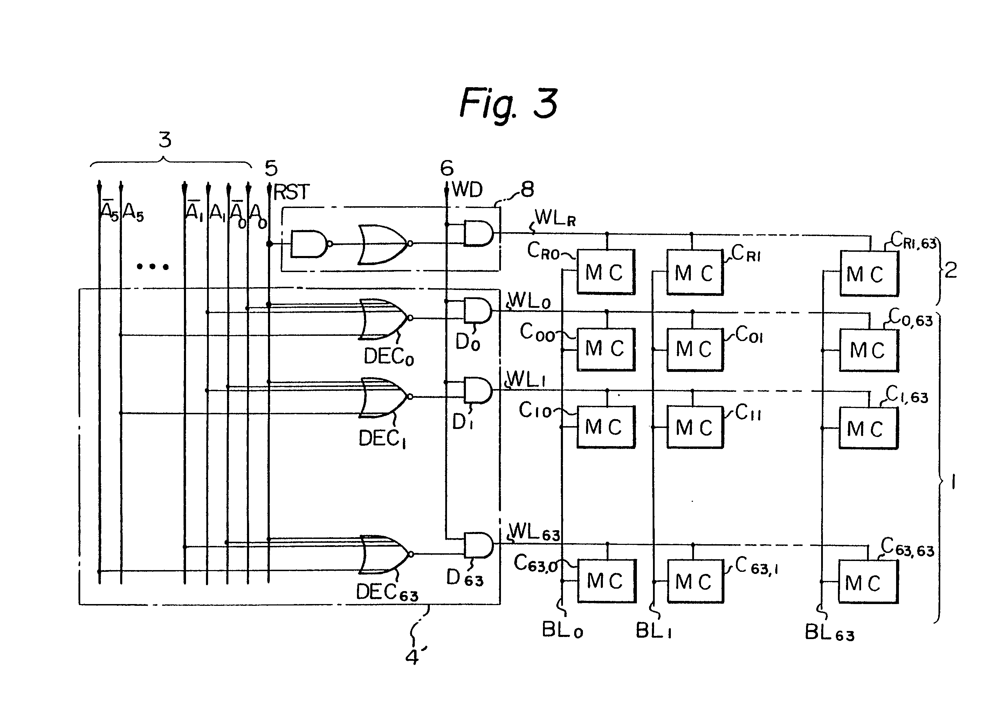

Figure 3 is a logic circuit diagram of the row address decoders and drivers 4' of Figure 2. In Figure 3, the row address decoders and drivers

4' comprise decoders $DEC_0$, $DEC_1$, . . ., $DEC_{63}$ formed by NOR gates and word drivers $D_0$, $D_1$, . . ., $D_{63}$ formed by AND gates each connected to one of the decoders $DEC_0$, $DEC_1$, . . ., $DEC_{63}$. Each decoder receives the address signals $A_0$ (or $\overline{A}_0$), $A_1$ (or $\overline{A}_1$) . . ., $A_5$ (or $\overline{A}_5$) from the address buffers 3 (Figure 2) and the signal RST from the decoder 5 (Figure 2), while each driver receives the clock signal WD from the clock 6 (Figure 2). When the potentials of the signals RST and WD are low and high, respectively, one of word lines $WL_0$, $WL_1$, . . ., $WL_{63}$ which corresponds to the address signals $A_0$, $\overline{A}_0$, $A_1$, $\overline{A}_1$, . . ., $A_5$, $\overline{A}_5$ is selected. The word lines $WL_0$, $WL_1$, . . ., $WL_{63}$ are connected to the 1st row memory cell array comprised of memory cells $C_{00}$, $C_{01}$, . . ., $C_{0,63}$; the 2nd row memory cell array comprised of memory cells $C_{10}$, $C_{11}$, . . ., $C_{1,63}$; and the 64th row memory cell array comprised of memory cells $C_{63,0}$, $C_{63,1}$, . . ., $C_{63,83}$, respectively. Contrary to this, when both of the potentials of the signals RST and WD are high, the driver 8 operates so as to select a word line $WL_R$ which is connected to the redundancy memory cell array 2 comprised of memory cells $C_{R0}$, $C_{R1}$, . . ., $C_{R63}$.

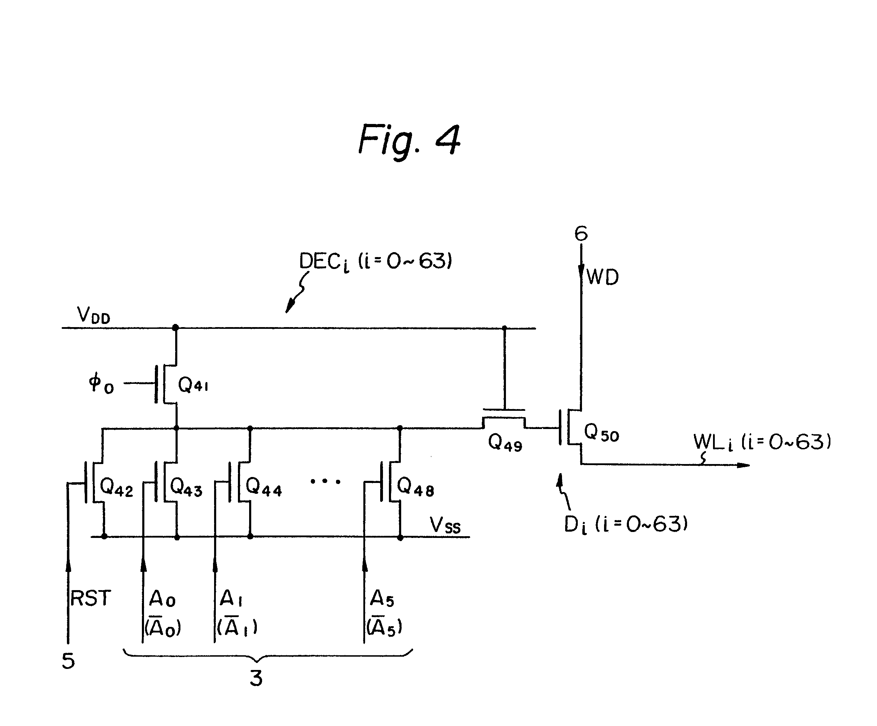

Figure 4 is a circuit diagram of the row address decoders and drivers 4' of Figure 2. In Figure 4, each decoder $DEC_i$ (i=0 through 63) comprises a load transistor $Q_{41}$ which receives a clock signal $\phi_0$, a transistor $Q_{42}$ for receiving the signal RST, transistors $Q_{43}$ through $Q_{48}$ for receiving the address signals $A_0$ (or $\overline{A}_0$), $A_1$ (or $\overline{A}_1$), . . ., $A_5$ (or $\overline{A}_5$) and a transistor $Q_{49}$ serving as a transfer gate. In addition, each word driver $D_i$ (i=0 through 63) comprises a transistor $Q_{50}$ having a gate connected to the decoder $DEC_i$, a drain for receiving the signal and a source connected to the word line $WL_i$. In this case, the areas of the transistors $Q_{41}$ through $Q_{48}$ are relatively small, since each current flowing there through is relatively small.

It should be noted that, in the row address decoders and drivers 4' of Figure 2, only the transistors $Q_{42}$ (Figure 4) are added as compared with the row address decoders and drivers 4 of Figure 1. In this case, each area of the transistors $Q_{42}$ is relatively small; however, a large number of the transistors $Q_{42}$, which number is, for example, sixty-four in the case of a 4,096 bit memory device, are necessary so that the entire device becomes large.

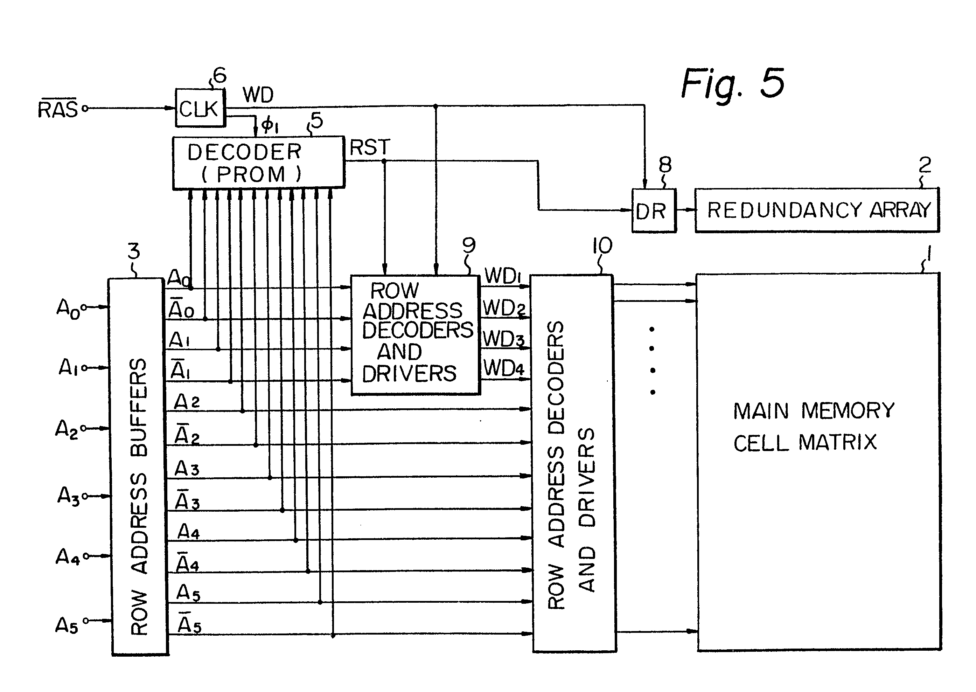

Figure 5 is a block diagram illustrating an embodiment of the semiconductor memory device according to the present invention. In Figure 5, the elements which are the same as those of Figure 2, are denoted by the same reference numerals. However, row address decoders and drivers 9 and 10 are provided instead of the row address decoders and drivers 4' of Figure 2. In Figure 5, the memory cell matrix 1 is divided into a plurality of sub matrix cell matrixes (not shown). The row address decoders and drivers 10 is used for selecting one sub memory cell matrix within the main memory cell matrix 1, while the row address decoders and drivers 9 is used for selecting one row memory cell array within each sub memory cell matrix.

The operation of the device of Figure 5 will now be explained.

When the address signals $A_0$, $\overline{A}_0$, $A_1$, $\overline{A}_1$, . . ., $A_5$, $\overline{A}_5$ do not correspond to the defective row address $ADD_x$, the decoder 5 generates the signal RST the potential of which is in this case low, so that the driver 8 is not activated. That is, the redundancy memory cell array 2 is not selected. Simultaneously, the row address decoders and drivers 9 execute a selection operation by using the address signals $A_0$, $\overline{A}_0$, $A_1$ and $\overline{A}_1$ so as to generate signals $WD_1$ through $WD_4$ to the row address decoders and drivers 10. In this case, one of the potentials of the signals $WD_1$ through $WD_4$ is high and the others are low. In addition, the row address decoders and drivers 10 execute a selection operation by using the address signals $A_2$, $\overline{A}_2$, . . ., $A_5$, $\overline{A}_5$ and the signals $WD_1$ through $WD_4$, so as to select one row memory cell array within the main memory cell matrix 1.

Contrary to the above, when the address signals $A_0$, $\overline{A}_0$, $A_1$, $\overline{A}_1$, . . ., $A_5$, $\overline{A}_5$ correspond to the defective row address $ADD_x$, the decoder 5 generates the signal RST, the potential of which is, in this case high, so that the driver 8 is activated so as to select the redundancy memory cell array 2. In addition, the row address decoders and drivers 9 are disabled by the high potential signal RST which also results in disabling of the row address decoders and drivers 10, since all the potentials of the signals $WD_1$ through $WD_4$ become low.

The row address decoders and drivers 9 and 10 will now be explained in more detail.

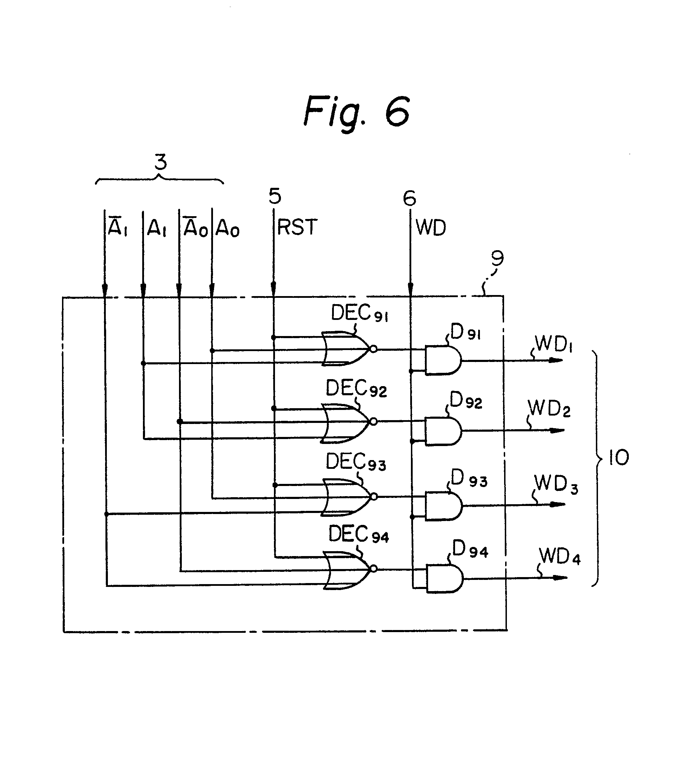

Figure 6 is a logic circuit diagram of the row address decoders and drivers 9 of Figure 5. In Figure 6, the row address decoders and drivers 9 comprise decoders $DEC_{91}$ through $DEC_{94}$ formed by NOR gates and word drivers $D_{91}$ through $D_{94}$ formed by AND gates. Each of the decoders $DEC_{91}$ through $DEC_{94}$ has an input connected to the output of the decoder 5 (Figure 5) and inputs for receiving the address signals $A_0$ (or $\overline{A}_0$) and $A_1$ (or $\overline{A}_1$). In addition, each of the word drivers $D_{91}$ through $D_{94}$ has an input connected to the clock 6 (Figure 5) and an input connected to one of the outputs of the decoders $DEC_{91}$ through $DEC_{94}$.

In Figure 6, when the potential of the signal RST is low, only one of the potentials of the outputs of the decoders $DEC_{91}$ through $DEC_{94}$ is high in accordance with the address signals $A_0$, $\overline{A}_0$, $A_1$ and $\overline{A}_1$ and, accordingly, only one of the potentials of the lines $WD_1$ through $WD_4$ is high, if the potential of the clock signal WD is high. In this case, the redundancy memory cell array 2 is not selected. Contrary to this, when the potential of the signal RST is high so as to select the redundancy memory cell array 2, all the potentials of the outputs of the decoders

$DEC_{91}$ through $DEC_{94}$ are low regardless of the address signals and accordingly, all the potentials of the lines $WD_1$ through $WD_4$ are low. That is, the row address decoders and drivers 9 are disabled.

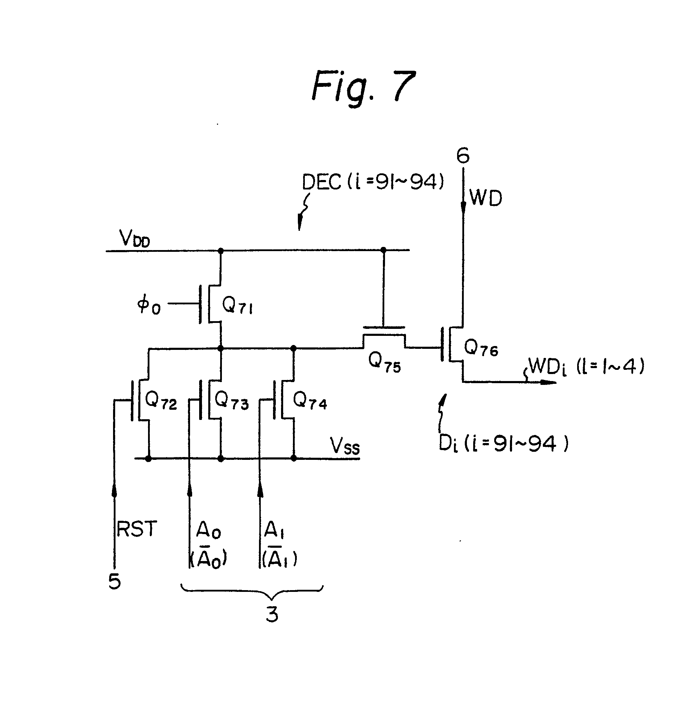

Figure 7 is a circuit diagram of the row address decoders and drivers 9 of Figure 5. In Figure 7 each of the decoders $DEC_i$ (i=91 through 94) comprises a load transistor $Q_{71}$ for receiving a clock signal $\phi_0$, transistors $Q_{72}$, and $Q_{73}$ and $Q_{74}$ for receiving the signals RST, $A_0$ (or $\overline{A}_0$) and $A_1$ (or $\overline{A}_1$), and a transistor $Q_{75}$ serving as a transfer gate. In addition, each of the word drivers $D_i$ (i=91 through 94) comprises a transistor $Q_{76}$ for passing the clock signal WD. In Figure 7, only the transistor $Q_{72}$ which serves as disabling means is added to a decoder used for a usual semiconductor memory device without a redundancy memory cell array. In addition, each area of the transistor $Q_{72}$ is relatively small, since the current flowing therethrough is relatively small.

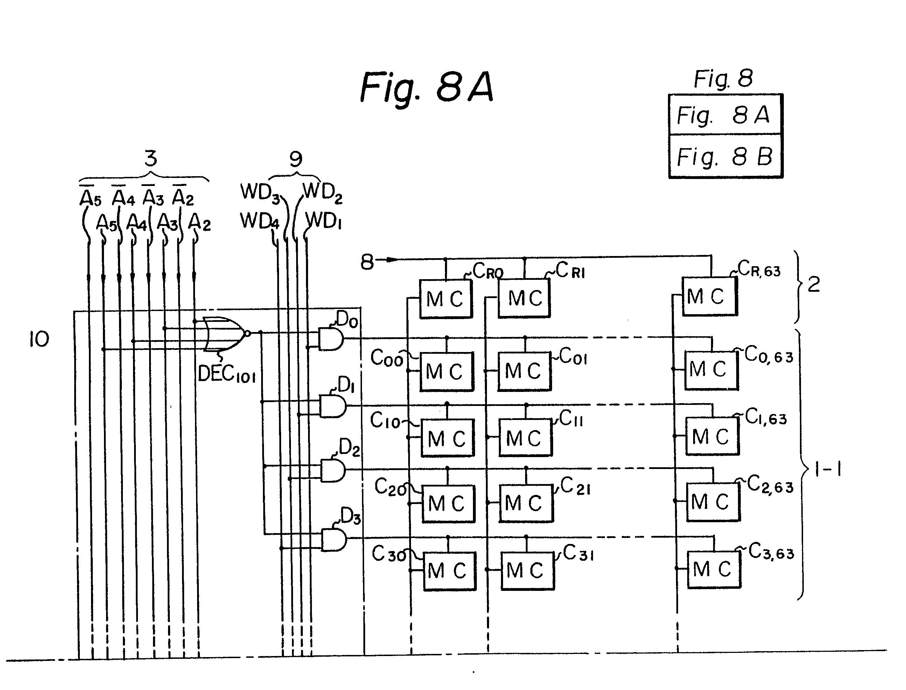

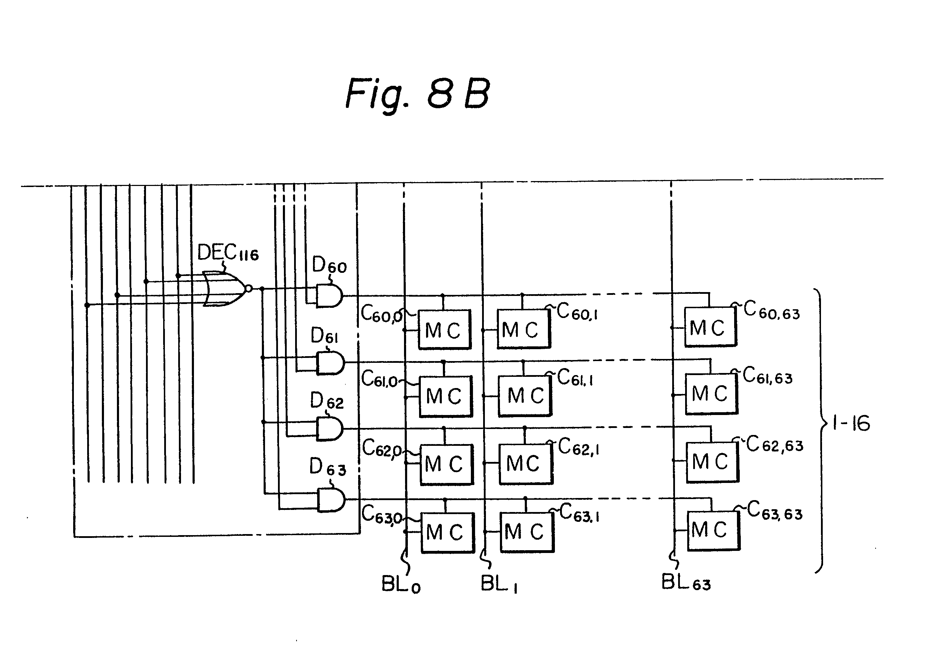

Figure 8 is a block diagram of the row address decoders and drivers 10 of Figure 5. In Figure 8, the decoders and drivers 10 comprise decoders $DEC_{101}$ through $DEC_{116}$ formed by NOR gates which receive the address signals $A_2$ (or $\overline{A}_2$), $A_3$ (or $\overline{A}_3$), $A_4$ (or $\overline{A}_4$) and $A_5$ (or $\overline{A}_5$), and word drivers $D_0$ through $D_{63}$. In this case, the decoder $DEC_{101}$ is used for selecting a sub memory cell matrix 1—1 comprised of the memory cells $C_{00}$, $C_{01}$, . . ., $C_{0,63}$; $C_{10}$, $C_{11}$, . . ., $C_{1,63}$; $C_{20}$, $C_{21}$, . . ., $C_{2,63}$; $C_{30}$, $C_{31}$, . . ., $C_{3,63}$. Similarly, the other decoders $DEC_{102}$ through $DEC_{116}$ are used for selecting sub memory cell matrixes 1—2 through 1—16, respectively.

In the case where the redundancy memory cell array 2 (Figure 5) is not selected, only one of the potentials of the signals $WD_1$ through $WD_4$ is high. For example, the potential of the signal $WD_1$ is high. As a result, the word drivers $D_0$, $D_4$, . . ., $D_{60}$ are activated. In addition, only one of the potentials of the outputs of the decoders $DEC_{101}$ through $DEC_{108}$ in accordance with the address signals $A_2$, $\overline{A}_2$, . . ., $A_5$ and $\overline{A}_5$ is high, for example, the potential of the output of the decoder $DEC_{101}$ is high. Therefore, only one row memory cell array formed by the memory cells $C_{00}$, $C_{01}$, . . ., $C_{0,63}$ is selected.

Contrary to the above, in the case where the redundancy memory cell array 2 (Figure 5) is selected, all the potentials of the signals $WD_1$ through $WD_4$ are low so that all the word drivers $D_0$ through $D_{63}$ are disabled. That is, the row address decoders and drivers 10 are disabled.

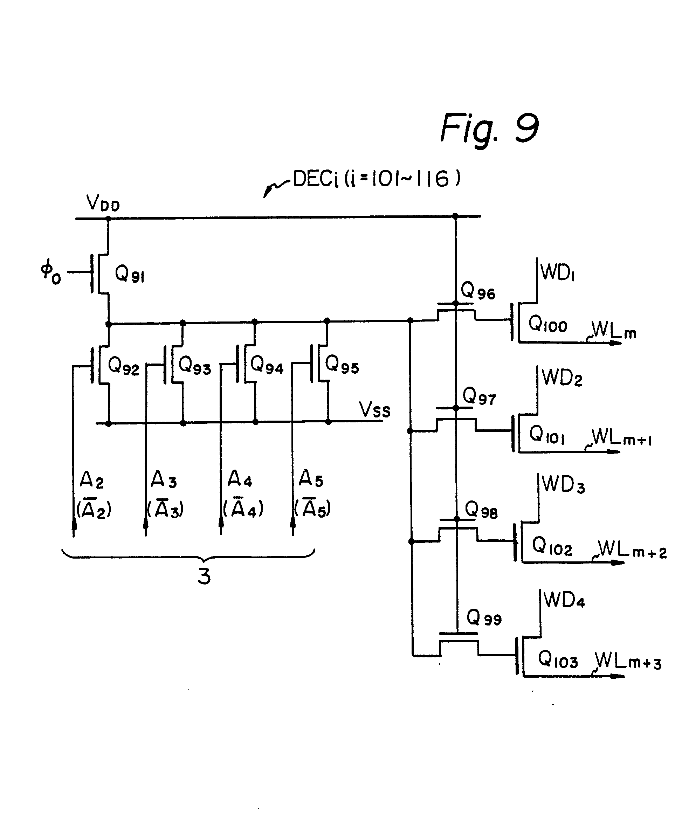

Figure 9 is a circuit diagram of the row address decoders and drivers 10 of Figure 5. In Figure 9, each of the decoders $DEC_i$ (i=101 through 116) comprises a load transistor $Q_{91}$ for receiving the clock signal $\phi_0$, transistors $Q_{92}$ through $Q_{95}$ for receiving the address signals $A_2$ (or $\overline{A}_2$) through $A_5$ (or $\overline{A}_5$), transistors $Q_{96}$ through $Q_{99}$ serving as transfer gates con-

nected to transistors $Q_{100}$ through $Q_{103}$ which serve as the word drivers.

As understood from Figures 3, through 9, the row address decoders and drivers 9 and 10 according to the present invention are simpler than the row address decoders and drivers 4' of the proposed device. In addition, the number of the transistors $Q_{72}$, the areas of which are small, used for the disabling means is reduced.

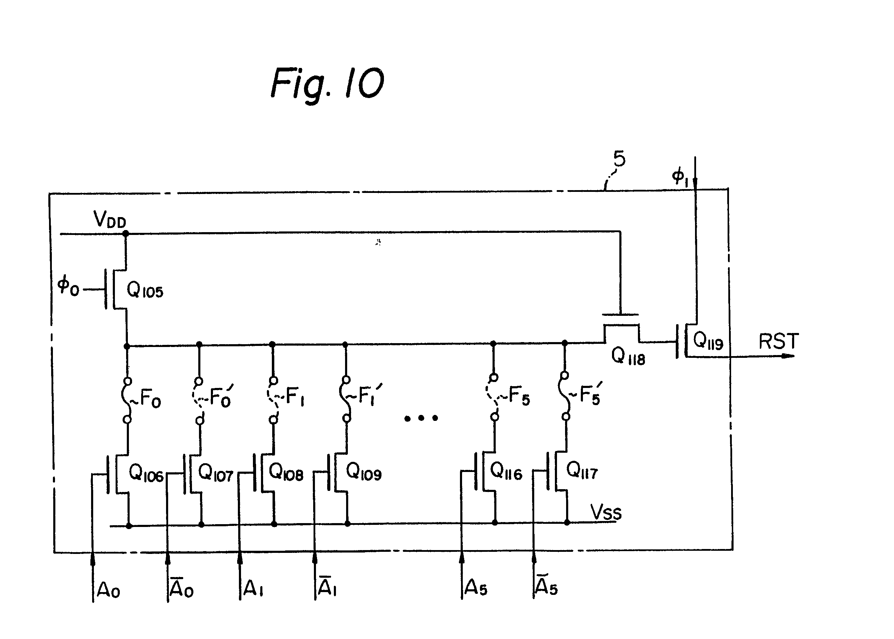

Figure 10 is a circuit diagram of the decoder 5 of Figure 5. In Figure 10, the decoder 5 is a PROM of a fuse type which comprises a load transistor $Q_{105}$, transistors $Q_{106}$ through $Q_{117}$ for receiving the address signals $A_0$, $\overline{A}_0$, $A_1$, $\overline{A}_1$, . . ., $A_5$, $\overline{A}_5$, respectively, and a transistor $Q_{118}$ serving as a transfer gate. Further, the transistors $Q_{106}$ through $Q_{117}$ are connected through fuses $F_0$, $F_0'$, $F_1$, $F_1'$, . . ., $F_5$, $F_5'$ to the transistor $Q_{105}$. If a defective memory cell is detected in the main memory cell matrix 1 (Figure 1), a row address to which said defective memory cell belongs is written. In this case, for example, the fuses such as $F_0'$, $F_1$ and $F_5$ are melted down by a programming means (not shown).

It should be noted that, in Figure 5, one redundancy memory cell array 2 is incorporated with the main memory matrix 1 and, accordingly, in spite of a defective memory cell, the device of Figure 5 can be used (in particular cases, two or more defective memory cells are generated in one row array; the device of Figure 5 can thus be used in spite of these defects.). However, in order to save two or more defective memory cells, two or more redundancy memory cell arrays 2 can be provided. In this case, there can be more than one decoder 5 and more than one redundancy memory cell array 2. In addition, in Figure 5, the redundancy memory cell array 2 is incorporated with the main memory cell matrix 1 along the rows thereof, but the redundancy memory cell array 2 can also be incorporated with the main memory cell matrix 1 along the columns thereof.

As explained above, the semiconductor memory device according to the present invention has an advantage, as compared with the proposed device, in that the area of the entire device is reduced, since the decoders and drivers are small.

**Claims**

1. A semiconductor memory device comprising a main memory cell matrix (1) which is divided into a plurality of sub memory cell matrixes, at least one redundancy memory cell array (2) associated with the main memory cell matrix, a first decoder means having a first decoder section (9) and a second decoder section (10), the first decoder section (9) selecting one memory cell array from each sub memory cell matrix and the second decoder section (10) selecting one sub memory cell matrix in accordance with a first part of received address information; a second decoder means (5) for generating a signal (RST) to select the redundancy memory cell array and to disable the selection of a memory cell array in the main memory cell matrix by the first decoder means (9, 10) in accordance with the first part of the received address information, third decoder means for selecting one memory cell from each memory cell array and from the redundancy memory cell array in accordance with a second part of received address information, and a clock (6) for supplying a clock signal (WD) to the redundancy memory cell array and to the first decoder means, characterised in that the first decoder section (9) receives a first portion (A0, A1) of the first part of the address information, the signal (RST) from the second decoder means (5), and the clock signal (WD) to generate word driving signals (WD1—WD4) so as to select the said one memory cell array from each sub memory cell matrix, and the second decoder section (10) receives the word driving signals and a second portion (A2—A5) of the first part of the address information to select the said one sub memory cell matrix, the first decoder section (9) being disabled by the signal (RST) from the second decoder means (5) to thereby disable the first decoder means (9, 10).

2. A device according to claim 1, wherein said first decoder section (9) comprises: a plurality of NOR gates (DEC91—DEC94) each having an input connected to receive the output (RST) of the second decoder means (5) and having inputs for receiving said first portion (A0—A1) of the first part of the address information; and a plurality of AND gates (D91—D94) each having an input connected to a respective one of the first NOR gates.

3. A device according to claim 1 or 2, wherein said second decoder section (10) comprises: a plurality of NOR gates (DEC101) each having inputs for receiving said second portion (A2—A5) of the first part of the address information; and a plurality of AND gates (D0—D3) each having inputs connected to a respective one of said NOR gates of the second decoder section and to one of the outputs of the first decoder section (9) and each having an output connected to one memory cell array of said main memory cell matrix.

4. A device according to claim 1, 2 or 3 wherein the second decoder means comprises a PROM for storing address information indicating a memory cell array including a defective memory cell when the defective memory cell is detected in the main memory cell matrix.

5. A device according to claim 4, wherein said PROM is of a fuse type.

6. A device according to any preceding claim, wherein the redundancy memory cell array is incorporated in the main memory cell matrix as a row array, and the first and second portion of the first part of the address information are row and column address information, respectively.

7. A device according to any one of claims 1 to 5, wherein the redundancy memory cell array is incorporated in the main memory cell matrix as a column array, and the first and second portion of the first part of the address information are column and row address information, respectively.

## Revendications

1. Dispositif de mémoire à semi-conducteurs comprenant une matrice principale (1) de cellules de mémoire qui est divisée en plusieurs matrices de cellules sous-mémoire, au moins un groupe (2) de cellules de mémoire à redondance associé avec la matrice principale de cellules de mémoire, un premier décodeur comprenant une première section de décodeur (9) et une seconde section de décodeur (10), la première section de décodeur (9) sélectionnant un groupe de cellules de mémoire dans chaque matrice de cellules de sous-mémoire et la seconde section de décodeur (10) sélectionnant une matrice de cellules de sous-mémoire en fonction d'une première partie d'une information d'adresses reçues, un second décodeur (5) pour produire un signal (RST) destiné à sélectionner le groupe de cellules de mémoire à redondance et à inhiber la sélection d'un groupe de cellules de mémoire dans la matrice principale de cellules de mémoire par le premier décodeur (9, 10) en fonction de la première partie d'informations d'adresses reçues, un troisième décodeur destiné à sélectionner une cellule de mémoire dans chaque groupe de cellules de mémoire et dans le groupe de cellules de mémoire à redondance en fonction d'une seconde partie de l'information d'adresses reçues, et une horloge (6) destiné à fournir un signal d'horloge (WD) au groupe de cellules de mémoire à redondance, et au prelier décodeur, caractérisé en ce que la première section de décodeur (9) reçoit une première partie (A0, A1) de la première partie de l'information d'adresses, le signal RST provenant du second décodeur (5) et le signal d'horloge (WD) pour produire des signaux d'attaque de mots (WD1—WD4) afin de sélectionner ledit groupe de cellules de mémoire dans chaque matrice de cellules de sous-mémoire, et la seconde section de décodeur (10) recevant les signaux d'attaque de mots et une seconde partie (A2—A5) de la première partie de l'information d'adresses pour sélectionner ladite matrice de cellules de sous-mémoire, la première section de décodeurs (9) étant inhibée par le signal (RST) provenant du second décodeur (5) pour inhiber ainsi le premier décodeur (9, 10).

2. Dispositif selon la revendication 1, dans lequel ladite première section de décodeur (9) comporte plusieurs portes NON-OU (DEC91—DEC94), ayant chacune une entrée connectée pour recevoir la sortie (RST) du second décodeur (5) et des entrées pour recevoir ladite première partie (A0—A1) de la première partie de l'information d'adresses et plusieurs portes ET (D91—D94) ayant chacune une entrée connectée à l'une respectives des premières portes NON-OU.

3. Dispositif selon la revendication 1 ou 2 dans lequel ladite seconde section de décodeur (10) comporte plusieurs portes NON-OU (DEC101) ayant chacune des entrées pour recevoir ladite seconde parties (A2—A5) de la première partie de l'information d'adresses, et plusieurs portes ET (D0—D3) ayant chacune des entrées connectées à l'une respectives desdites portes NON-OU de la seconde section de décodeur et à l'une des sorties de la première section de décodeur (9) et ayant chacune une sortie connectée à un groupe de cellules de mémoire de ladite matrice principale de cellule de mémoire.

4. Dispositif selon la revendication 1, 2 ou 3 dans lequel le second décodeur consiste en une PROM pour mémoriser des informations d'adresses indiquant un groupe de cellules de mémoire comprenant une cellule de mémoire défectueuse quand la cellule de mémoire défectueuse est détectée dans la matrice principale de cellule de mémoire.

5. Dispositif selon la revendication 4, dans lequel ladite PROM est d'un type à fusion.

6. Dispositif selon l'une quelconque des revendications précédentes, dans lequel le groupe de cellules de mémoire à redondance est incorporé dans la matrice principale de cellules de mémoire comme un groupe de rangées et la première et la seconde parties de la première partie de l'information d'adresses sont respectivement des informations d'adresses de rangées et de colonnes.

7. Dispositif selon l'une quelconque des revendications 1 à 5, dans lequel le groupe de cellules de matrice à redondance est incorporé dans la matrice principale de cellules de mémoire comme un groupe de colonnes et la première et la seconde parties de la première partie de l'information d'adresses sont des informations d'adresses de colonnes et de rangées respectivement.

## Patentansprüche

1. Halbleiterspeichervorrichtung mit einer Hauptspeicherzellenmatrix (1), die in einer Anzahl von Subspeicherzellenmatrizen unterteilt ist, wenigstens einer Redundanzspeicherzellenanordnung (2), welche der Hauptspeicherzellenmatrix zugeordnet ist, einer ersten Decodereinrichtung, die einen ersten Decoderabschnitt (9) und einen zweiten Decoderabschnitt (10) aufweist, von denen der erste Decoderabschnitt (9) eine Speicherzellenanordnung von jeder Subspeicherzellenmatrix und der zweite Decoderabschnitt (10) eine Subspeicherzellenmatrix in Übereinstimmung mit einem ersten Teil einer empfangenen Adresseninformation ausfüllt; einer zweiten Decodereinrichtung (5) zur Erzeugung eines Signals (RST), um die Redundanzspeicherzellenanordnung auszuwählen und die Auswahl einer Speicherzellenanordnung in der Hauptspeicherzellenmatrix durch die erste Decodereinrichtung (9, 10) in Übereinstimmung mit dem ersten Teil der empfangenen Adresseninformation unwirksam zu machen, einer dritten Decodereinrichtung zur Auswahl einer Speicherzelle von jeder Speicherzellenanordnung und von der Redundanzspeicherzellenanordnung in Übereinstimmung mit einem zweiten Teil der empfangenen Adresseninformation, und einem Taktgeber (6), welcher der Redundanzspeicherzellenanordnung und der ersten Decodereinrichtung ein Taktsignal (WD) liefert, dadurch gekennzeichnet, daß der erste Decoderabschnitt (9) einen ersten Abschnitt (AO, A1) des ersten Teils der Adresseninformation, das Signal (RST) von der zweiten Decodereinrichtung (5) und das Taktsignal (WD) empfängt, um Worttreibersignale (WD1—WD4) so zu erzeugen, um eine Speicherzellenanordnung von jeder Subspeicherzellenmatrix auszuwählen, und daß der zweite Decoderabschnitt (10) die Worttreibersignale und eine zweiten Abschnitt (A2—A5) des ersten Teils der Adresseninformation empfängt, um die eine genannte Subspeicherzellenmatrix auszuwählen, wobei der erste Decoderabschnitt (9) durch das Signal (RST) von der zweiten Decodereinrichtung (5) unwirksam gemacht wird, um dadurch die erste Decodereinrichtung (9, 10) unwirksam zu machen.

2. Vorrichtung nach Anspruch 1, bei welcher der erste Decoderabschnitt (9) umfaßt:

eine Anzahl von NOR-Schaltungen (DEC91—DEC94), die jeweils einen Eingang aufweisen, der zum Empfang des Ausgangssignals (RST) der zweiten Decodereinrichtung (5) angeschlossen ist, und die Eingänge zum Empfang des ersten Abschnitts (AO—A1) des ersten Teils der Adresseninformation haben, und

eine Anzahl von UND-Schaltungen (D91—D94), welche jeweils einen Eingang haben, der mit einer entsprechenden NOR-Schaltung verbunden ist.

3. Vorrichtung nach Anspruch 1 oder 2, bei welcher der genannte zweite Decoderabschnitt (10) umfaßt:

eine Anzahl von NOR-Schaltungen (DEC101), die jeweils Eingänge zum Empfang der genannten zweiten Abschnitte (A2—A5) des ersten Teils der Adresseninformation aufweisen, und

eine Anzahl von UND-Schaltungen (DO—D3), die jeweils Eingänge haben, die mit einem entsprechenden der genannten NOR-Schaltungen des zweiten Decoderabschnitts und mit einem der Ausgänge des ersten Decoderabschnitts (9) verbunden sind, und die jeweils einen Ausgang haben, der mit einer Speicherzellenanordnung der genannten Hauptspeicherzellenmatrix verbunden ist.

4. Vorrichtung nach Anspruch 1, 2 oder 3, bei welcher die zweite Decodereinrichtung ein PROM zur Speicherung von Adresseninformation aufweist, welche eine Speicherzellenanordnung anzeigt, das eine defekte Speicherzelle enthält, wenn die defekte Speicherzelle in der Hauptspeicherzellenmatrix festgestellt ist.

5. Vorrichtung nach Anspruch 4, bei welcher das genannte PROM vom Schmelztyp ist.

6. Vorrichtung nach einem der vorhergehenden Ansprüche, bei welcher die Redundanzspeicherzellenanordnung in der Hauptspeicherzellenmatrix als eine Reihenanordnung inkorporiert ist, und der erste und der zweite Abschnitt des ersten Teils der Adresseninformation Reihenadresseninformation bzw. Spaltenadresseninformation sind.

7. Vorrichtung nach einem der Ansprüche 1 bis 5, bei welcher die Redundanzspeicherzellenanordnung in der Hauptspeicherzellenmatrix als eine Spaltenanordnung inkorporiert ist, und der erste und der zweite Abschnitt des ersten Teils der Adresseninformation Spaltenadresseninformation bzw. Reihenadresseninformation sind.

*Fig. I*

0 029 322

Fig. 2

*Fig. 3*

Fig. 4

0 029 322

Fig. 5

0 029 322

# Fig. 6

## Fig. 7

DEC (i =91~94)

WD

$V_{DD}$

$\phi_0$ — | $Q_{71}$

$Q_{75}$

$Q_{76}$

WD_i (l=1~4)

$Q_{72}$  $Q_{73}$  $Q_{74}$

$V_{SS}$

$D_i$ (i=91~94)

RST

$A_0$
$(\bar{A}_0)$

$A_1$
$(\bar{A}_1)$

5

3

6

Fig. 8A

Fig. 8

Fig. 8A

Fig. 8B

0 029 322

# Fig. 8 B

0 029 322

Fig. 9

Fig. 10